Europäisches Patentamt

European Patent Office

Office européen des brevets

(19)

(11) **EP 1 020 728 B1**

(12) **FASCICULE DE BREVET EUROPEEN**

(45) Date de publication et mention
de la délivrance du brevet:
**04.05.2005 Bulletin 2005/18**

(51) Int Cl.⁷: **G01R 15/18**

(21) Numéro de dépôt: **00400042.8**

(22) Date de dépôt: **10.01.2000**

(54) **Dispositif de mesure d'un courant circulant dans un conducteur.**

Anordnung zum messen eines Stromes in einer Leitung

Device for measuring a current in a conductor

(84) Etats contractants désignés:
**CH DE ES GB IT LI PT SE**

(30) Priorité: **12.01.1999 FR 9900235**

(43) Date de publication de la demande:
**19.07.2000 Bulletin 2000/29**

(73) Titulaire: **Peugeot Citroen Automobiles SA**
**92200 Neuilly sur Seine (FR)**

(72) Inventeur: **Audoux, Philippe**
**92250 La Garenne Colombes (FR)**

(74) Mandataire:
**Habasque, Etienne Joel Jean-François et al**
**Cabinet Lavoix**
**2, Place d'Estienne d'Orves**
**75441 Paris Cédex 09 (FR)**

(56) Documents cités:
**US-A- 4 274 052        US-A- 4 616 174**

**Description**

La présente invention concerne un dispositif de mesure d'un courant circulant dans un conducteur.

De tels dispositifs sont par exemple utilisés pour mesurer des courants continus ou variables dans le temps.

On connaît déjà dans l'état de la technique (voir par exemple le document WO-A-94/23305), un certain nombre de dispositifs de mesure de ce type, qui comportent au moins un capteur magnétique muni de moyens formant circuit magnétique se présentant sous la forme par exemple d'un tore magnétique disposé autour du conducteur et sur lesquels sont placés des moyens formant bobinage, raccordés à des moyens d'alimentation en courant de compensation pour engendrer dans le circuit magnétique, un champ magnétique opposé à celui créé dans celui-ci par le courant à mesurer afin d'obtenir un champ nul dans les moyens formant circuit magnétique, et des moyens d'analyse du courant de compensation pour déterminer le courant à mesurer.

Ces dispositifs de mesure, dits à isolation galvanique, fonctionnent en effet sur le principe de la compensation magnétique.

Les moyens formant circuit magnétique d'un tel dispositif portent en général des moyens formant bobinage constitués de Nc spires, tandis que le courant à mesurer Ip rayonne dans ces moyens formant circuit magnétique, un champ magnétique Hp.

Un courant Ic, dit de compensation, est injecté dans ces moyens formant bobinage et rayonne un champ magnétique Hc opposé au champ Hp.

Les moyens d'alimentation sont alors adaptés pour asservir le courant Ic, de telle manière que Ht (total) = Hp + Hc = 0, ou bien encore Ip - Nc x Ic = 0.

Lorsque cette condition est remplie, il suffit de mesurer le courant Ic pour en déduire la valeur de Ip, c'est-à-dire du courant à mesurer.

La condition d'asservissement Ht = 0 est déterminée par exemple grâce à une sonde placée dans un entrefer des moyens formant circuit magnétique, cette sonde étant par exemple une sonde à effet Hall ou magnétorésistive.

En fait, ces sondes ne déterminent pas exactement Ht = 0, mais Bt = 0, Bt étant l'induction dans le tore.

Or, cette condition ne reflète pas exactement la condition Ht = 0. La différence est liée aux perturbations engendrées par l'hystérésis magnétique avec la présence de l'induction rémanente Br du matériau magnétique des moyens formant circuit magnétique.

De plus, de tels dispositifs sont en général très sensibles à la température. On constate en effet une dérive de la tension d'offset de la sonde avec la température. Les moyens d'alimentation asservis dont le premier composant est la sonde de mesure, se trouvent en général à proximité des moyens formant circuit magnétique. Cette proximité interdit toute mesure en milieu sévère, c'est-à-dire dans lequel la température est supérieure à 150°C.

Par ailleurs, les dispositifs de mesure de l'état de la technique fonctionnent souvent avec des alimentation symétriques +/- Vcc, Vcc pouvant varier de 6 à 24 V. Ces tensions symétriques sont relativement difficiles à obtenir dans des applications automobiles où les dispositifs de mesure sont alimentés par la tension de la batterie de celui-ci, cette tension étant une tension unipolaire variant entre 6 et 16 V par exemple.

On connaît également du document US-A-4 616 174 un dispositif conforme au préambule de la revendication 1.

Le document US-A-4 274 052 décrit un dispositif de mesure d'un courant ayant un seul transducteur magnétique qui utilise le principe d'asservissement d'un harmonique pair d'une tension présente aux bornes des moyens formant bobinage par un courant de compensation.

Enfin, les dispositifs connus dans l'état de la technique sont également relativement complexes et donc coûteux à réaliser, présentent un encombrement relativement important, sont sensibles aux champs magnétiques parasites et présentent une plage de mesure relativement peu aisée à adapter.

Le but de l'invention est donc de résoudre ces problèmes, en proposant un dispositif de mesure qui soit simple, fiable, d'un encombrement et d'un poids réduits et dont le coût de fabrication soit également le plus réduit possible.

A cet effet, l'invention a pour objet un dispositif de mesure d'un courant circulant dans un conducteur, de type comportant au moins un capteur magnétique associé au conducteur et comportant des moyens formant circuit magnétique et des moyens formant bobinage raccordés à des moyens d'alimentation en courant de compensation pour engendrer dans les moyens formant circuit magnétique, un champ magnétique opposé au champ créé dans celui-ci par le courant à mesurer et des moyens d'analyse du courant de compensation pour déterminer le courant à mesurer, le capteur magnétique étant un capteur différentiel comprenant au moins deux transducteurs magnétiques à circuit magnétique et bobinage, dont les bobinages sont raccordés en série et en opposition, caractérisé en ce que les moyens d'alimentation comprennent des moyens de superposition sur le courant de compensation d'un courant périodique radiofréquence et des moyens d'analyse d'un harmonique pair de la tension résultante présente aux bornes des moyens formant bobinage pour asservir l'amplitude de celui-ci à zéro, en faisant varier le courant de compensation.

L'invention sera mieux comprise à l'aide de la description qui va suivre donnée uniquement à titre d'exemple et faite en se référant aux dessins annexés sur lesquels:

- la figure 1 représente un schéma synoptique illustrant la structure et le fonctionnement d'un dispositif de mesure de courant selon l'invention;
- la figure 2 représente un schéma synoptique illustrant la structure et le fonctionnement d'une variante de réalisation d'un dispositif de mesure de courant selon l'invention; et
- la figure 3 représente un schéma synoptique illustrant la structure et le fonctionnement d'une autre variante de réalisation d'un dispositif de mesure de courant selon l'invention.

On reconnaît en effet sur ces figures, un dispositif de mesure d'un courant lp circulant dans un conducteur désigné par la référence générale 1.

Ce dispositif comporte au moins un capteur magnétique 1a associé au conducteur 1 et muni de moyens formant circuit magnétique, désignés par la référence générale 2 sur ces figures, sur lesquels sont placés des moyens formant bobinage, désignés par la référence générale 3, raccordés à des moyens d'alimentation en courant de compensation qui seront décrits plus en détail par la suite.

En fait, le capteur magnétique 1a est un capteur différentiel comprenant au moins deux transducteurs magnétiques 1b et 1c à circuit magnétique et bobinage, placés à des distances différentes du conducteur 1 et dont les bobinages sont raccordés en série et en opposition.

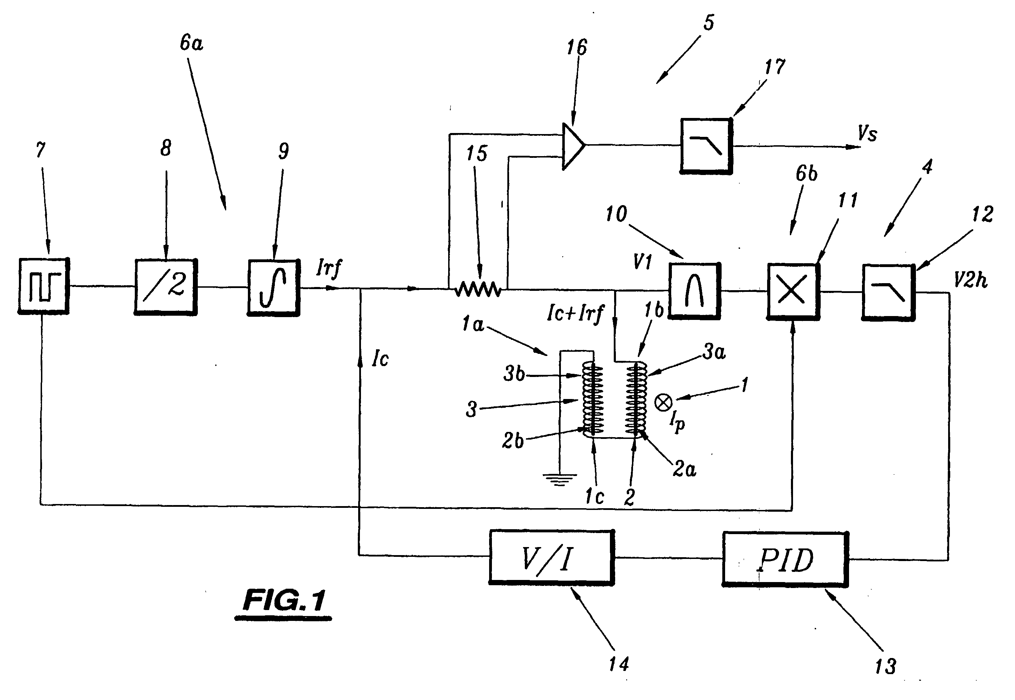

C'est ainsi que sur cette figure 1, les transducteurs magnétiques 1b et 1c sont distincts et séparés l'un de l'autre et comportent chacun un circuit magnétique 2a, 2b, respectivement, et un bobinage 3a, 3b, respectivement.

Comme cela est illustré sur cette figure, ces transducteurs magnétiques 1b et 1c peuvent être disposés côte à côte et parallèlement dans un plan transversal à l'axe du conducteur 1 traversé par le courant lp à mesurer.

Comme cela est également illustré sur cette figure 1, les bobinages 3a et 3b respectivement de ces transducteurs sont raccordés en série et en opposition.

Le courant de compensation est désigné par la référence lc sur ces figures.

Les moyens d'alimentation sont quant à eux désignés de façon générale par la référence 4 et sont adaptés pour délivrer aux moyens formant bobinage 3, c'est-à-dire aux bobinages 3a et 3b raccordés en série et en opposition, un courant de compensation lc permettant d'engendrer dans les moyens formant circuit magnétique, c'est-à-dire dans les circuits magnétiques respectifs des transducteurs, un champ magnétique opposé au champ créé dans ceux-ci par le courant à mesurer.

De plus, le dispositif de mesure comporte des moyens 5 d'analyse du courant de compensation lc pour déterminer le courant lp à mesurer.

A cet effet, les moyens d'alimentation 4 comprennent des moyens 6a de superposition sur le courant de compensation lc d'un courant périodique radio-fréquence, par exemple sinusoïdal, désigné par la référence lrf sur ces figures et des moyens 6b d'analyse d'un harmonique pair de la tension résultante présente aux bornes des moyens formant bobinage 3 du capteur, pour asservir l'amplitude de celui-ci à zéro en faisant varier le courant de compensation lc.

On conçoit alors que la tension aux bornes de ces moyens formant bobinage 3 comporte un deuxième harmonique $V2f = V12f + V22f$, qui est en fait la somme du deuxième harmonique de la tension présente aux bornes du premier transducteur 1b plongé dans un champ magnétique H1 et du deuxième harmonique de la tension présente aux bornes du deuxième transducteur 1c plongé dans un champ magnétique H2.

La tension résultante V2f est nulle dans le cas où les champs magnétiques H1 et H2 sont identiques en raison du montage en série et en opposition des bobinages.

Par contre, il apparaît un signal V2f quand le champ magnétique moyen sur le premier transducteur est différent du champ magnétique moyen sur le deuxième transducteur.

On conçoit en effet que le champ total vu par le transducteur 1b est la somme du champ créé par le courant lp à une première distance d1 et du champ magnétique parasite.

Le champ total vu par le transducteur 1c est la somme du champ créé par le courant lp à une seconde distance d2 et du champ magnétique parasite.

La contribution à V2f du champ magnétique parasite est nulle et la tension V2f différence des contributions du courant lp et fonction des distances d1 et d2 est proportionnelle à lp.

Cette structure différentielle permet ainsi d'éliminer l'influence des champs magnétiques parasites uniformes, comme le champ magnétique terrestre, et d'éviter l'utilisation de blindages magnétiques pour améliorer la résolution du dispositif.

La mesure du courant lp dérive alors directement de ce qui a été expliqué ci-dessus.

En effet, le courant lc de compensation est proportionnel au courant lp à mesurer selon la relation :

$$lp = K \times lc.$$

Le coefficient de sensibilité K est obtenu par étalonnage précis. Celui-ci est fonction des distances séparant respectivement les premier et second transducteurs du conducteur, du nombre de spires des bobinages et de la géométrie de ceux-ci. Ce coefficient implique, pour des mesures précises, un étalonnage individuel des capteurs et la prise en compte de la dérive en température de ce coefficient de sensibilité.

Le courant périodique radio-fréquence lrf se présente par exemple sous la forme $lrf(t) = 10 \times Sin(2\pi \times FOxt)$ et est superposé au courant de compensation lc dans les moyens formant bobinage 3 du capteur. Ce courant lrf engendre un champ Hrf dans les moyens formant circuit magnétique.

Si l0 est suffisamment grand, ce champ sature de part et d'autre le matériau présent dans ces moyens en l'absence de champ continu dans le capteur.

Lorsque le champ Ht est égal à 0, le matériau magnétique est saturé de part et d'autre périodiquement et de façon symétrique. L'induction B et le flux f induits présentent alors également par définition une symétrique. La tension induite aux bornes des moyens formant bobinage 3 est fonction du flux f variant dans le temps (loi de Lentz). Cette tension présente donc une symétrie par rapport à la tension de référence des moyens formant bobinage et la décomposition harmonique d'un tel signal de tension montre que les harmoniques d'ordre 2n, c'est-à-dire pairs, n étant un entier positif différent de 0, sont nuls.

Dans le cas contraire, où Ht est différent de 0, on montre que dans les mêmes conditions d'excitation, le signal de tension induit aux bornes des moyens formant bobinage n'est plus symétrique. L'analyse harmonique d'un tel signal montre l'apparition d'harmoniques d'ordre 2n, n étant un entier positif différent de 0, dont l'amplitude et la phase sont fonctions du champ Ht.

Les moyens d'alimentation sont alors adaptés pour analyser par exemple le second harmonique présent dans la tension aux bornes des moyens formant bobinage 3 et pour asservir le courant de compensation lc sur cette information d'amplitude du second harmonique égale à 0.

On notera également que cet asservissement peut s'effectuer sur n'importe quel autre harmonique pair du signal.

A cet effet, les moyens de superposition désignés par la référence générale 6a comprennent par exemple un oscillateur désigné par la référence générale 7 sur ces figures. Dans le cas de l'analyse du second harmonique du signal de tension, cet oscillateur délivre un signal à une fréquence double de celle du courant périodique lrf, à l'entrée d'un diviseur de fréquence par deux, désigné par la référence générale 8, dont la sortie est reliée à un module de mise en forme de signaux désigné par la référence générale 9, relié aux moyens formant bobinage 3.

Les moyens d'analyse 6b comprennent quant à eux un amplificateur passe-bande désigné par la référence générale 10, qui est raccordé aux moyens formant bobinage 3 pour amplifier et sélectionner l'harmonique pair correspondant du signal de tension présent aux bornes de ceux-ci, la sortie de cet amplificateur passe-bande étant reliée à un multiplicateur 11 recevant également en entrée un signal issu de l'oscillateur 7 à la fréquence 2F0, pour assurer une détection synchrone.

La sortie de ce multiplicateur est reliée à un filtre passe-bas 12 qui délivre un signal de tension V2h proportionnel à l'amplitude et à la phase de l'harmonique correspondant, à un correcteur de type PID par exemple, désigné par la référence générale 13.

La sortie de ce correcteur de type PID est reliée à un convertisseur tension-courant désigné par la référence générale 14 délivrant le courant lc de compensation aux moyens formant bobinage 3.

Les moyens d'analyse 5 du courant de compensation lc comprennent quant à eux une résistance désignée par la référence générale 15 sur cette figure, en série avec les moyens formant bobinage 3 et aux bornes de laquelle sont raccordées les entrées d'un amplificateur 16, dont la sortie est reliée à un filtre passe-bas 17, délivrant une tension Vs proportionnelle à ce courant de compensation lc et donc au courant à mesurer lp lorsque les conditions évoquées précédemment sont remplies.

On conçoit alors que, dans ce qui vient d'être décrit, on met en oeuvre une méthode de détection synchrone pour l'analyse du second harmonique du signal de tension présent aux bornes des moyens formant bobinage 3.

L'amplificateur passe-bande 10 effectue une pré-sélection et une amplification du second harmonique, tandis que l'ensemble multiplicateur 11 et filtre passe-bas 12 réalise l'analyse harmonique et délivre en sortie la tension V2h proportionnelle à l'amplitude et à la phase du second harmonique de la tension V1 aux bornes des moyens formant bobinage.

Cette tension V2h image du second harmonique est traitée par le correcteur 13, par exemple de type PID, et le convertisseur tension-courant 14 délivre le courant de compensation lc aux moyens formant bobinage.

Les modules d'oscillateur, de diviseur et de mise en forme 7, 8, 9, respectivement, engendrent le courant périodique lrf à la fréquence F0 et le signal de référence à la fréquence 2F0 pour la détection synchrone, le courant périodique radio-fréquence résultant lrf étant superposé sur le courant lc délivré par le convertisseur 14, dans les moyens formant bobinage 3.

Le courant circulant dans ces moyens, c'est-à-dire lrf + lc est prélevé grâce à la résistance 15 qui peut être une résistance shunt de précision et l'amplificateur 16. L'information haute fréquence est éliminée par le filtre passe-bas 17 pour fournir en sortie une tension Vs = A x lp, A étant un coefficient déterminé, ce qui permet d'obtenir le courant à mesurer lp.

Différentes technologies de fabrication des moyens formant circuit magnétique et des moyens formant bobinage peuvent être envisagées.

C'est ainsi par exemple qu'une technologie de bobinage linéaire avec du fil classique ou thermo-adhérent peut être utilisée.

Une autre technologie, dite planar, peut également être envisagée, le bobinage étant réalisé alors par gravure et raccordement de pistes de cuivre.

On conçoit alors que le dispositif selon l'invention présente un certain nombre d'avantages au niveau de sa miniaturisation importante, de ses coûts de fabrication réduits, de sa sensibilité réduite aux champs magnétiques parasites, ce qui permet d'éviter l'utilisation de blindages magnétiques auxiliaires et de l'adaptation aisée de la plage de mesure de celui-ci sans changement de capteur, par un simple réglage de la distance séparant le conducteur et le capteur.

Un tel dispositif de mesure constitue un élément métrologique alimenté sous une tension unipolaire d'un système de gestion d'un courant électrique et les différents moyens électroniques associés aux moyens formant circuit magnétique et bobinage peuvent être placés à distance de ceux-ci et être reliés à ceux-ci par l'intermédiaire de lignes de transmission de signaux, ce qui permet d'assurer un traitement de ceux-ci à distance, la détection synchrone permettant le rejet des parasites électromagnétiques présents.

Cette télémesure permet de disposer un ou plusieurs capteurs de ce type sur un réseau électrique d'un véhicule automobile par exemple et d'inclure les moyens électroniques dans un calculateur placé en milieu protégé, tel que par exemple un calculateur de contrôle du fonctionnement du moteur du véhicule, etc....

A titre d'exemple, le circuit magnétique de chaque transducteur peut présenter une section droite magnétique dont la surface est comprise entre 0,05 mm$^2$ et 0,4 mm$^2$. Le bobinage de chacun de ceux-ci peut être déterminé quant à lui de façon classique.

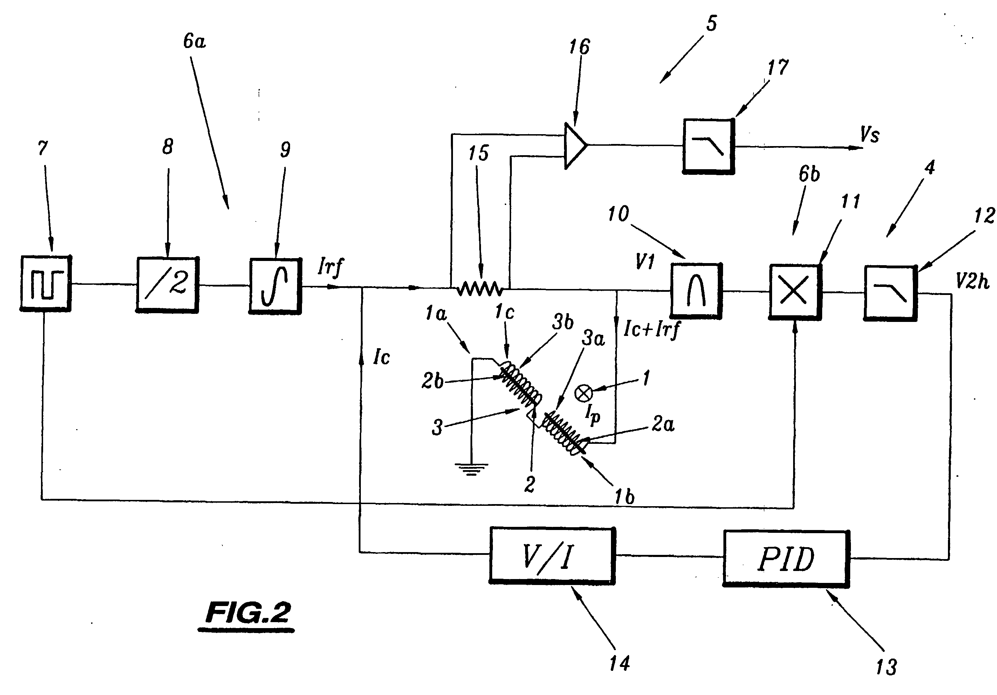

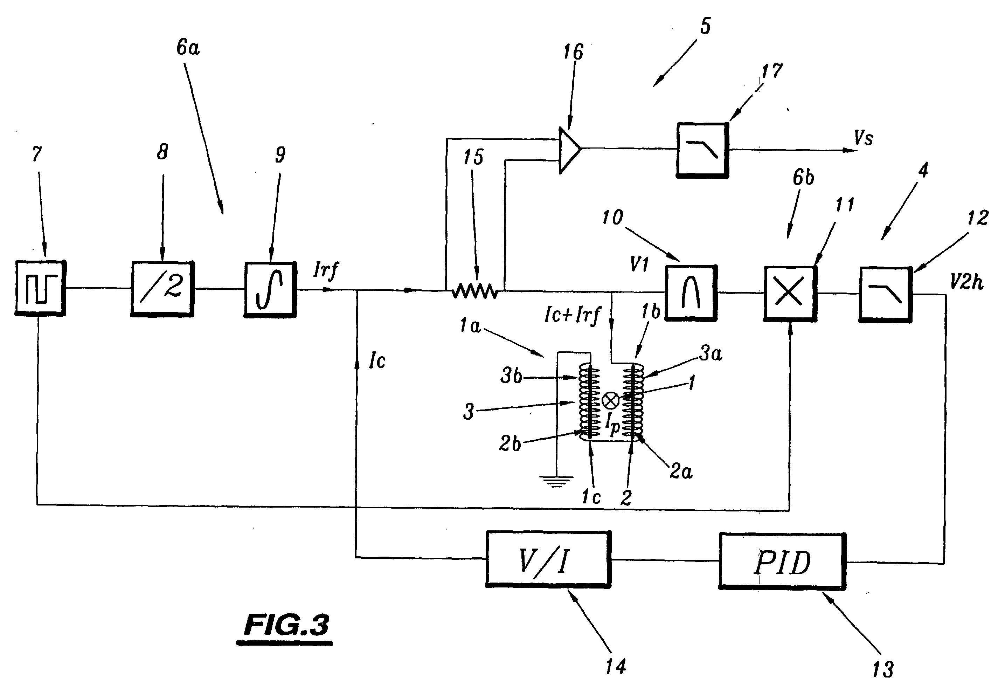

Il va de soi bien entendu que différents modes de réalisation de ce dispositif peuvent être envisagés comme ceux illustrés sur les figures 2 et 3, dans lesquelles des numéros de référence identiques désignent des pièces identiques ou analogues à celles représentées sur la figure 1.

Le dispositif représenté sur cette figure 2 diffère de celui représenté sur la figure 1, essentiellement par une disposition différente des deux transducteurs magnétiques 1b, 1c du capteur différentiel 1a. En effet, alors que sur la figure 1, les transducteurs 1b, 1c sont disposés côte à côte et parallèlement, dans le dispositif représenté sur la figure 2, ces transducteurs 1b et 1c sont disposés avec leurs axes inclinés et décalés par rapport au conducteur 1 et ceux-ci peuvent par exemple être alignés l'un avec l'autre.

Dans l'exemple illustré, les transducteurs 1b et 1c comprennent chacun un circuit magnétique 2a,2b et un bobinage 3a, 3b séparés. Il va de soi qu'un circuit magnétique commun aux deux transducteurs peut également être utilisé. On dispose alors sur ce circuit magnétique commun, les deux bobinages des deux transducteurs en ayant soin d'inverser leur sens de bobinage pour permettre leur raccordement en série et en opposition.

Le fonctionnement de cette variante de réalisation est identique à celui du dispositif représenté sur la figure 1, de sorte qu'on ne le décrira pas dans le détail.

D'autres modes de réalisation encore de ce dispositif peuvent être envisagés comme celui représenté sur la figure 3, dans lequel le conducteur 1 est placé à égale distance entre les transducteurs 1b et 1c.

La contribution du courant lp est la somme des contributions des transducteurs 1b et 1c. Le dispositif fonctionne alors en différentiel mais uniquement pour les champs parasites.

Bien entendu, des circuits magnétiques et des bobinages de formes variées peuvent être utilisés.

On peut choisir des formes de circuits magnétiques diverses, identiques pour les deux transducteurs, et disposées symétriquement par rapport à un axe, dans un plan perpendiculaire au conducteur de courant, comme par exemple des arcs de cercle ou d'ellipse.

## Revendications

1. Dispositif de mesure d'un courant circulant dans un conducteur (1), du type comportant au moins un capteur magnétique (1a) adapté à être associé au conducteur (1) et comportant des moyens (2) formant circuit magnétique et des moyens (3) formant bobinage raccordés à des moyens d'alimentation (4) en courant de compensation (lc) pour engendrer dans les moyens formant circuit magnétique (2) un champ magnétique opposé au champ créé dans celui-ci par le courant à mesurer, et des moyens d'analyse (5) du courant de compensation pour déterminer le courant à mesurer (lp), le capteur magnétique (1a) étant un capteur différentiel comprenant au moins deux transducteurs magnétiques (1b, 1c) à circuit magnétique et bobinage, dont les bobinages (3a, 3b) sont raccordés en série et en opposition, **caractérisé en ce que** les moyens d'alimentation (4) comprennent des moyens (6a) de superposition sur le courant de compensation (Ic) d'un courant périodique radiofréquence (Irf) et des moyens (6b) d'analyse d'un harmonique pair de la tension résultante présente aux bornes des moyens formant bobinage (3) pour asservir l'amplitude de celui-ci à zéro, en faisant varier le courant de compensation (Ic).

2. Dispositif selon la revendication 1, **caractérisé en ce que** les transducteurs magnétiques (1b, 1c) sont distincts et séparés l'un de l'autre et sont disposés parallèlement côte à côte.

3. Dispositif selon la revendication 1, **caractérisé en ce que** les transducteurs (1b, 1c) sont adaptés à être disposés avec leurs axes inclinés et décalés par rapport au conducteur (1).

4. Dispositif selon la revendication 3, **caractérisé en ce que** les transducteurs (1b, 1c) comportent des circuits magnétiques et des bobinages séparés.

5. Dispositif selon la revendication 3, **caractérisé en ce que** les transducteurs (1b, 1c) sont disposés dans l'alignement l'un de l'autre et comprennent chacun un bobinage disposé sur un circuit magnétique commun.

6. Dispositif selon l'une quelconque des revendications précédentes, **caractérisé en ce que** les moyens d'alimentation comprennent un oscillateur (7) délivrant un signal à une fréquence multiple de celle du courant périodique (Irf) à l'entrée d'un diviseur de fréquence (8) dont la sortie est reliée à l'entrée d'un module de mise en forme de signaux (9) dont la sortie est raccordée aux moyens formant bobinage (3).

7. Dispositif selon l'une quelconque des revendications précédentes, **caractérisé en ce que** les moyens d'alimentation comprennent un amplificateur passe-bande (10) dont l'entrée est raccordée aux moyens formant bobinage (3) pour amplifier et sélectionner l'harmonique pair correspondant et dont la sortie est reliée à l'entrée d'un multiplicateur (11) recevant également en entrée le signal de sortie de l'oscillateur (7), et dont la sortie est reliée à l'entrée d'un filtre passe-bas (12) pour une analyse synchrone du signal et délivrer un signal de tension (V2h) proportionnel à l'amplitude et à la phase de l'harmonique correspondant.

8. Dispositif selon la revendication 7, **caractérisé en ce que** la sortie du filtre passe-bas (12) est reliée à l'entrée d'un correcteur de type PID (13) dont la sortie est reliée à un convertisseur tension-courant (14) dont la sortie est raccordée aux moyens formant bobinage (3) pour délivrer à celui-ci le courant de compensation (Ic).

9. Dispositif selon l'une quelconque des revendications précédentes, **caractérisé en ce que** les moyens (5) d'analyse du courant de compensation (Ic) comprennent une résistance (15) en série avec les moyens formant bobinage (3), un amplificateur (16) raccordé aux bornes de cette résistance (15) et un filtre passe-bas (17) raccordé à la sortie de l'amplificateur, pour délivrer un signal de sortie (Vs) proportionnel au courant de compensation (Ic).

10. Dispositif selon l'une quelconque des revendications précédentes, **caractérisé en ce que** l'harmonique correspondant est le second harmonique.

11. Dispositif selon l'une quelconque des revendications précédentes, **caractérisé en ce que** le ou chacun des circuits magnétiques présente une section droite magnétique dont la surface est comprise entre 0,05 mm$^2$ et 0,4 mm$^2$.

12. Dispositif selon l'une quelconque des revendications précédentes, **caractérisé en ce que** les moyens formant circuit magnétique (2) et les moyens formant bobinage (3), d'une part, et les différents moyens du dispositif raccordés à ceux-ci, d'autre part, sont disposés à distance les uns des autres et sont raccordés par des lignes de transmission de signaux.

**Patentansprüche**

1. Vorrichtung zum Messen eines Stromes, der in einem Leiter (1) fließt, mit wenigstens einem Magnetsensor (1a), der dem Leiter (1) zugeordnet werden kann, und Einrichtungen (2), die einen Magnetkreis bilden, sowie Einrichtungen (3), umfasst, die eine Wicklung bilden, die mit Einrichtungen (4) zum Versorgen mit einem Kompensationsstrom (Ic) verbunden sind, um in den Einrichtungen (2), die einen Magnetkreis bilden, ein magnetisches Feld zu erzeugen, das dem Feld entgegengesetzt ist, das darin durch den zu messenden Strom erzeugt wird, und mit Einrichtungen (5) zum Analysieren des Kompensationsstromes, um den zu messenden Strom (Ip) zu bestimmen, wobei der Magnetsensor (1a) ein Differenzsensor ist, der wenigstens zwei Magnetwandler (1b, 1c) am Magnetkreis und der Wicklung umfasst, deren Wicklungen (3a, 3b) in Reihe gegeneinander geschaltet sind, **dadurch gekennzeichnet, dass** die Einrichtungen (4) zum Versorgen Einrichtung (6a) zum Überlagern des Kompensationsstromes (Ic) mit einem periodischen hochfrequenten Strom (Irf) und Einrichtungen (6b) zum Analysieren einer geradzahligen Harmonischen der sich ergebenden Spannung an den Anschlüssen der Einrichtungen (3), die eine Wicklung bilden, umfassen um deren Amplitude auf Null herabzusetzen, indem der Kompensationsstrom (Ic) verändert wird.

2. Vorrichtung nach Anspruch 1, **dadurch gekennzeichnet, dass** die Magnetwandler (1b, 1c) einzeln und voneinander getrennt und parallel Seite an Seite angeordnet sind.

3. Vorrichtung nach Anspruch 1, **dadurch gekennzeichnet, dass** die Wandler (1b, 1c) so ausgebildet sind, dass sie mit ihren Achsen bezüglich des Leiters (1) geneigt und versetzt angeordnet werden können.

4. Vorrichtung nach Anspruch 3, **dadurch gekennzeichnet, dass** die Wandler (1b, 1c) getrennte Magnetkreise und Wicklungen umfassen.

5. Vorrichtung nach Anspruch 3, **dadurch gekennzeichnet, dass** die Wandler (1b, 1c) zueinander ausgerichtet angeordnet sind und jeweils eine Wicklung umfassen, die auf einem gemeinsamen Magnetkreis angeordnet sind.

6. Vorrichtung nach einem der vorhergehenden Ansprüche, **dadurch gekennzeichnet, dass** die Einrichtungen zum Versorgen einen Oszillator (7) umfassen, der ein Signal mit einer Frequenz gleich einem Vielfachen der Frequenz des periodischen Stroms (Irf) dem Eingang eines Frequenzteilers (8) liefert, dessen Ausgang mit dem Eingang eines Moduls (9) zum Formen von Signalen verbunden ist, dessen Ausgang mit den Einrichtungen (3) verbunden ist, die eine Wicklung bilden.

7. Vorrichtung nach einem der vorhergehenden Ansprüche, **dadurch gekennzeichnet, dass** die Einrichtungen zum Versorgen einen Bandpassverstärker (10) umfassen, dessen Eingang mit den Einrichtungen (3) verbunden ist, die eine Wicklung bilden, um die entsprechende geradzahlige Harmonische zu verstärken und auszuwählen, dessen Ausgang mit dem Eingang eines Multiplikators (11) verbunden ist, der an einem Eingang gleichfalls das Ausgangssignal des Oszillators (7) empfängt und dessen Ausgang mit dem Eingang eines Tiefpassfilters (12) verbunden ist, um das Signal synchron zu analysieren und ein Spannungssignal (V2h) abzugeben, das zu der Amplitude und der Phase der entsprechenden Harmonischen proportional ist.

8. Vorrichtung nach Anspruch 7, **dadurch gekennzeichnet, dass** der Ausgang des Tiefpassfilters (12) mit dem Eingang eines Korrekturgliedes (13) vom Proportional-Integral-Differenzial-Typ verbunden ist, dessen Ausgang mit einem Spannungsstromwandler (14) verbunden ist, dessen Ausgang mit den Einrichtungen (3) verbunden ist, die eine Wicklung bilden, um diesen den Kompensationsstrom (Ic) zu liefern.

9. Vorrichtung nach einem der vorhergehenden Ansprüche, **dadurch gekennzeichnet, dass** die Einrichtungen (5) zum Analysieren des Kompensationsstromes (Ic) einen Widerstand (15) in Reihe mit den Einrichtungen (3), die eine Wicklung bilden, einen Verstärker (16), der mit den Anschlüssen dieses Widerstandes (15) verbunden ist, und ein Tiefpassfilter (17) umfassen, das mit dem Ausgang des Verstärkers verbunden ist, um ein Ausgangssignal (Vs) zu liefern, das proportional zum Kompensationsstrom (Ic) ist.

10. Vorrichtung nach einem der vorhergehenden Ansprüche, **dadurch gekennzeichnet, dass** die entsprechende Harmonische die zweite Harmonische ist.

11. Vorrichtung nach einem der vorhergehenden Ansprüche, **dadurch gekennzeichnet, dass** der oder jeder Magnetkreis einen magnetischen Querschnitt aufweist, dessen Fläche zwischen 0,05 mm$^2$ und 0,4 mm$^2$ liegt.

12. Vorrichtung nach einem der vorhergehenden Ansprüche, **dadurch gekennzeichnet, dass** die Einrichtungen (2), die einen Magnetkreis bilden, und die Einrichtungen (3), die eine Wicklung bilden, einerseits und die verschiedenen Einrichtungen der Vorrichtung, die damit verbunden sind, andererseits, in einem Abstand voneinander angeordnet und über Signalübertragungsleitungen miteinander verbunden sind.

## Claims

1. Device for measuring a current which circulates in a conductor (1), of the type comprising at least one magnetic sensor (1a) which is designed to be associated with the conductor (1) and comprises means (2) which form a magnetic circuit and means (3) which form a winding and are connected to means (4) for supplying with compensation current (Ic) in order to generate in the means (2) which form the magnetic circuit (2) a magnetic field which opposes the field created in the latter by the current to be measured, and means (5) for analysis of the compensation current in order to determine the current (Ip) to be measured, the magnetic sensor (1a) being a differential sensor comprising at least two magnetic transducers (1b, 1c) with a magnetic circuit and winding, the windings (3a, 3b) of which are connected in series and in opposition, **characterised in that** the supply means (4) comprise means (6a) for superimposition on the compensation current (Ic) of a periodic radiofrequency current (Irf) and means (6b) for analysis of an even harmonic of the resulting voltage which is present at the terminals of the means which form a winding (3), in order to set the amplitude of the latter to zero by making the compensation current (Ic) vary.

2. Device according to claim 1, **characterised in that** the magnetic transducers (1b, 1c) are distinct and separate from one another, and are disposed parallel side by side.

3. Device according to claim 1, **characterised in that** the transducers (1b, 1c) are designed to be disposed with their axes inclined and offset relative to the conductor (1).

4. Device according to claim 3, **characterised in that** the transducers (1b, 1c) comprise separate windings and magnetic circuits.

5. Device according to claim 3, **characterised in that** the transducers (1b, 1c) are disposed aligned with one another, and each comprise a winding which is disposed on a common magnetic circuit.

6. Device according to any one of the preceding claims, **characterised in that** the supply means comprise an oscillator (7) which supplies a signal at a frequency which is multiple that of the periodic current (Irf) at the input of a frequency divider (8), the output of which is connected to the input of a module for forming signals (9), the output of which is connected to the means (3) which form a winding.

7. Device according to any one of the preceding claims, **characterised in that** the supply means comprise a band-pass amplifier (10), the input of which is connected to the means (3) which form a winding, in order to amplify and select the corresponding even harmonic, and the output of which is connected to the input of a multiplier (11) which also receives as input the output signal of the oscillator (7), and the output of which is connected to the input of a low-pass filter (12) for synchronous analysis of the signal, and to supply a voltage signal (V2h) which is proportional to the amplitude and phase of the corresponding harmonic.

8. Device according to claim 7, **characterised in that** the output of the low-pass filter (12) is connected to the input of a corrector of the PID type (13), the output of which is connected to a voltage-current converter (14), the output of which is connected to the means which form a winding (3) in order to provide the latter with the compensation current (Ic).

9. Device according to any one of the preceding claims, **characterised in that** the means (5) for analysis of the compensation current (Ic) comprise a resistor (15) in series with the means which form a winding (3), an amplifier (16) which is connected to the terminals of this resistor (15) and a low-pass filter (17) which is connected to the output of the amplifier in order to supply an output signal (Vs) which is proportional to the compensation current (Ic).

10. Device according to any one of the preceding claims, **characterised in that** the corresponding harmonic is the second harmonic.

11. Device according to any one of the preceding claims, **characterised in that** the or each magnetic circuit has a straight magnetic section, the surface of which is between 0.05 mm$^2$ and 0.4 mm$^2$.

12. Device according to any one of the preceding claims, **characterised in that** the means which form a magnetic circuit (2) and the means which form a winding (3) on the one hand, and the different means of the device which are connected to the latter on the other hand, are disposed spaced from one another and are connected by signal transmission lines.

**FIG.1**

EP 1 020 728 B1

**FIG.2**

EP 1 020 728 B1

**FIG.3**